# EUROPEAN PATENT APPLICATION

(11) **EP 0 851 481 A2**
(43) Date of publication of application: **01.07.1998**
(21) Application number: 97204012.5
(22) Date of filing: 18.12.1997
(51) Int. Cl.: H01L 21/768

(54) **Method of making an encapsulated metal lead for multi-level interconnect**

(30) Priority: 18.12.1996 US 33361 P
(71) Applicant: Texas Instruments Incorporated, Dallas, Texas 75265 (US)
(72) Inventor: Gillespie, Paul M., allen, TX 75002 (US)
(74) Representative: Holt, Michael

(57) **Abstract**

A method of fabricating a lead for use in conjunction with a semiconductor device and the lead. A surface is provided which is disposed on a semiconductor substrate and has a via (5) with electrically conductive material (9) therein extending to the substrate. A lead is formed on the surface having an optional barrier layer (11) disposed on the surface and contacting the electrically conductive material (9). An electrically conductive metal layer (13) is formed which is disposed over and contacting the barrier layer (11) and has sidewalls. An anti-reflective coating (15) is formed on the electrically conductive metal layer (13) remote from the barrier layer (11). The electrically conductive metal layer (13) is encapsulated between the barrier layer (11) and the anti-reflective layer (15) with a composition taken from the class consisting of TiN, W, Ti, and Si₃N₄. The composition is them removed except from the sidewalls of the electrically conductive metal layer (13) to encapsulate the electrically conductive layer. The electrically conductive metal layer (13) is indented relative to the barrier layer (11) and the anti-reflective layer (15) to form an I-shape with the barrier layer and the anti-reflective layer. The step of encapsulating comprises the step of chemically vapor depositing a conformal layer of the composition (17) over the previously structure resulting and then isotropically etching a portion of the composition (17) to provide a sidewall on the electrically conductive metal layer (13) conformal to the sidewalls of the barrier layer (11) and the anti-reflective layer (15).

## Description

### TECHNICAL FIELD OF THE INVENTION

This invention relates generally to semiconductor devices, and more particularly, to a fully encapsulated metal lead for multi-level interconnects for semiconductor devices.

### BACKGROUND OF THE INVENTION

In the fabrication of semiconductor devices, typical cross-sectional profiles of advanced multi-level metallization leads have been in the shape of an I-beam. In general, the lead is formed over an oxide layer and is connected to silicon or the like beneath the oxide layer through a via extending through the oxide layer which is filled with tungsten. This is accomplished by depositing a layer of titanium nitride into the via and over the oxide followed by a layer of chemically vapor deposited (CVD) tungsten (W) which fills the via and may extend over the titanium nitride. The tungsten is etched back in standard manner to leave tungsten only within the via as well as a layer of titanium nitride within the via and over the oxide. A layer of titanium nitride is then deposited, followed by a layer of aluminum alloy (about 0.5% copper (Cu) and then followed by a layer of titanium nitride. The upper layer of titanium nitride is then masked and an etchant is used to etch through the layers of titanium nitride, aluminum and the titanium nitride. Since the aluminum etches more rapidly than the titanium nitride, there is provided an I-shaped lead with exposed outer aluminum surfaces having an upper anti-reflective titanium nitride layer, etc., an intermediate aluminum alloy layer and a low barrier metal layer of titanium nitride, titanium tungsten, etc.

A problem with leads having exposed surfaces is that of electromigration, though other properties of such leads can also be improved as will be discussed hereinbelow.

### SUMMARY OF THE INVENTION

In accordance with the present invention, there is provided an encapsulated metal lead for multi-level interconnect for semiconductor devices. This is achieved by a chemical vapor deposition (CVD) film formed after a metal etch followed by an isotropic etch to leave the encapsulating film on the edges or sidewalls of the lead. Top and bottom encapsulation layers are deposited by physical vapor deposition (PVD) as a three layer stack film such as, for example, TiN-A1 alloy TiN. By fully encapsulating metal leads, electromigration properties are enhanced, stress induced notching is reduced and the encapsulant also can act as a diffusion barrier.

The lead is fabricated over an oxide layer and is connected to silicon or the like beneath the oxide layer through a via extending through the oxide layer which is filled with tungsten as in the prior art. This is accomplished by depositing a layer of a barrier metal, preferably titanium nitride, titanium tungsten, as well as other well known barrier metals, into the via and over the oxide followed by a layer of chemically vapor deposited (CVD) tungsten (W), aluminum-filled vias and the like which fills the via and may extend over the barrier metal. The tungsten is etched back in standard manner to leave tungsten only within the via as well as a layer of barrier metal within the via which is optionally removed and over the oxide. A layer of titanium nitride is then deposited over the existing layer of titanium nitride (any aluminum alloy with current carrying capability can also be used), followed by a layer of aluminum alloy (preferably about 0.5% copper (Cu) (any aluminum alloy with current carrying capability can also be used) and then followed by a blanket deposition of a conformal CVD film which encapsulates the entire structure fabricated up to that point. The CVD film is preferably one of titanium nitride, tungsten, titanium, silicon nitride, etc. CVD film is then isotropically etched. The resulting structure is as in the prior art, but with a sidewall encapsulating film of the CVD material. Since the material being etch is entirely the CVD material, the I-shaped structure of the prior art is avoided and the sidewalls are essentially straight along their entire length.

The benefits derived from the above described lead are: (1) improvement in electromigration due to the stress of the encapsulating film inhibiting extrusions or accumulation of metal transported from the voided region, (2) stress induced notching is reduced due to reduced surface diffusion and (3) the encapsulation film can act as a diffusion barrier.

### BRIEF DESCRIPTION OF THE DRAWINGS

The present invention will now be further described by way of example, with reference to the accompanying drawings in which:

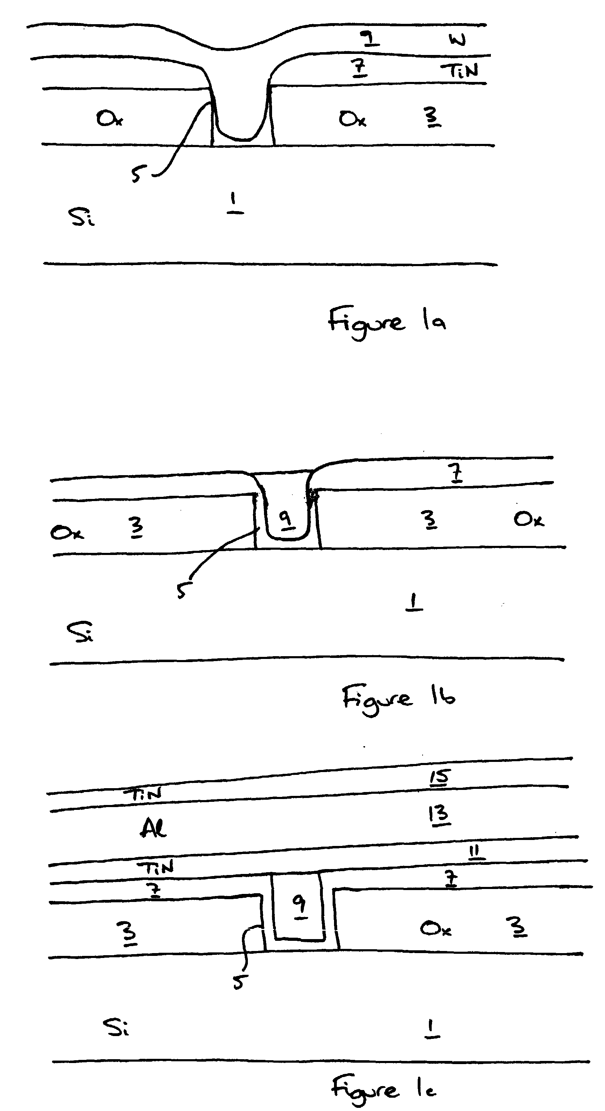

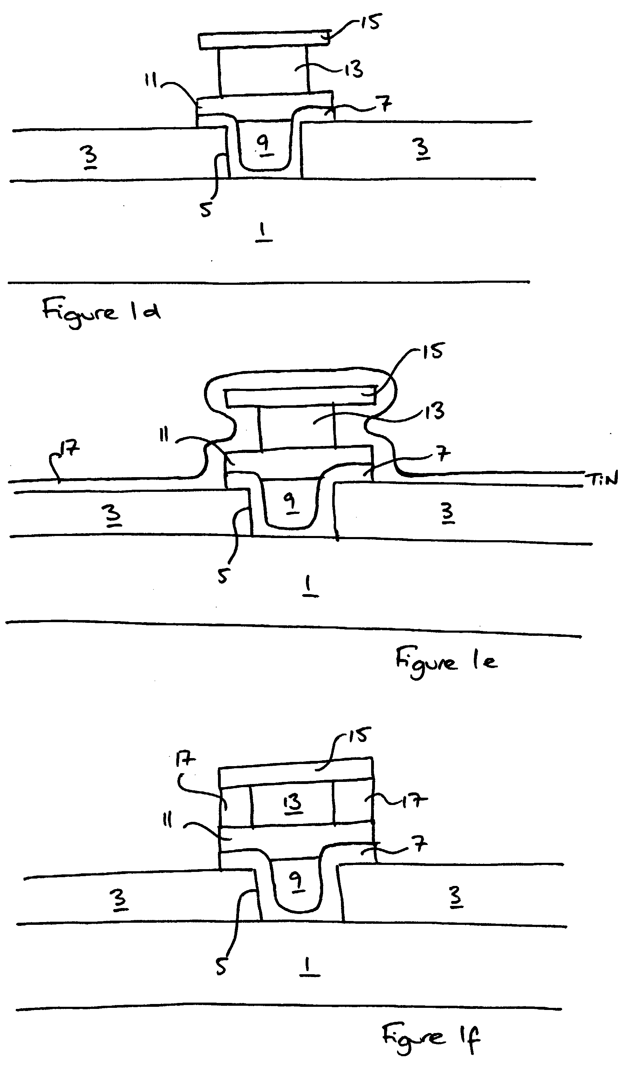

Figures 1a to 1f are a process flow for the fabrication of a lead in accordance with the present invention.

### DESCRIPTION OF THE PREFERRED EMBODIMENT

Referring first to Figure 1a, there is shown a typical semiconductor silicon chip 1 to which electrical connection is to be made, such as to a pad thereon or the like. An oxide layer 3 is disposed over at least a portion of the surface of the silicon chip 1 and contains a via 5 therethrough extending down to the silicon chip to where the electrical connection is to be made. A layer of titanium nitride 7 is deposited in the via 5 as well as over the surface of the oxide layer 3 by sputtering. A layer of tungsten 9 is then conformally deposited to fill the via 5 and extend over the titanium nitride layer 7 by chemical vapor deposition.

Referring now to Figure 1b, the tungsten layer 9 is etched back so that it is now present only within the via 5, As shown in Figure 1c, a layer of titanium nitride 11 is then deposited over the exposed surface followed by a layer of aluminum or aluminum alloy 13, preferably aluminum having 0.5 per cent copper which is then followed by a layer of titanium nitride 15 as shown in Figure 1c. The structure of Figure 1c is then masked over the via 5 and slightly beyond the via and isotropic etching then takes place down to the oxide layer 3 as shown in Figure 1d, removing all of the titanium nitride layers 7 and 11, the aluminum layer 13 and the titanium nitride layer 15 except. the portion thereof under the mask (not shown). The aluminum layer 15 is etched farther in than are the titanium nitride layers 7, 11 and 15 because the etch chemistry reacts faster toward the aluminum than it does to the titanium nitride.

The structure of Figure 1d is fully encapsulated by a blanket deposition of a conformal CVD film of titanium nitride 17 as shown in Figure le which is then followed by an isotropic etch of the titanium nitride layer 17, leaving titanium nitride 17 as a sidewall on the aluminum layer 13 as shown in Figure 1f.

Though the invention has been described with reference to a specific preferred embodiment thereof, many variations and modifications will immediately become apparent to those skilled in the art.

## Claims

**1.** A method of fabricating a lead for a semiconductor device comprising the steps of:
forming a lead disposed on a surface having an electrically conductive metal layer disposed over said surface and an anti-reflective coating on said electrically conductive layer remote from said surface; and
encapsulating said electrically conductive metal layer with a material which substantially prevents electromigration of electrically conductive metal.

**2.** The method of Claim 1, further comprising:
forming a barrier layer disposed between said surface and said electrically conductive layer.

**3.** The method of Claim 2, wherein said step of encapsulating comprises encapsulating said electrically conductive metal layer between said barrier layer and said anti-reflective layer.

**4.** The method of any of Claims 1 to 3, wherein said step of encapsulating comprises encapsulating said electrically conductive metal layer with a material selected from a group of material comprising: TiN, W, Ti and Si₃N₄.

**5.** The method of any of Claims 1 to 4, wherein said step of encapsulating comprises the steps of depositing said material substantially over and around said lead and istropically etching said material to provide substantially vertical sidewalls on said lead.

**6.** The method of Claim 5, wherein said step of etching said electrically conductive metal layer to provide sidewalls comprises etching said electrically conductive metal layer to provide sidewalls that are indented relative to said barrier layer and said anti-reflective layer and form a substantially I-shape.

**7.** The method of any of Claims 1 to 6, wherein said step of forming said lead on said surface comprises forming said lead on a surface of an oxide layer disposed on a semiconductor material.

**8.** The method of any of Claims 1 to 7, wherein said surface is an oxide layer disposed on semiconductor material and further including the step of providing a via with electrically conductive material therein extending from said barrier layer to said semiconductor material.

**9.** A method of fabricating a lead for a semiconductor device comprising the steps of:
providing a surface disposed on a semiconductor substrate and having a via with electrically conductive material therein extending to said substrate;
forming a lead disposed on said surface having an electrically conductive metal layer disposed on said surface and contacting said electrically conductive material and having sidewalls;
forming an anti-reflective coating on said electrically conductive metal layer remote from said surface;
encapsulating said electrically conductive metal layer with a material that substantially prevents electromigration of said electrically conductive metal; and
removing said material except from said sidewalls of said electrically conductive metal layer to encapsulate said electrically conductive layer.

**10.** The method of Claim 9, further comprising:
a barrier layer disposed between said surface and said electrically conductive layer.

**11.** The method of Claim 10, wherein said step of encapsulating comprises encapsulating said electrically conductive metal layer between said barrier layer and said anti-reflective layer.

**12.** The method of Claim 9 or Claim 10, wherein said step pf encapsulating comprises encapsulating said elecrically conductive metal layer with a material selected from a group of materials comprising: TiN, W, Ti and Si₃N₄.

**13.** The method of any of Claims 9 to 12, wherein said step of etching said electrically conductive metal layer to provide sidewalls comprises etching said electrically conductive metal layer to provide sidewalls that are indented relative to said barrier layer and said anti-reflective layer and form a substantially I-shape with said barrier layer and said anti-reflective layer.

**14.** The method of any of Claims 9 to 13, further comprising depositing a conformal layer of said material over the structure resulting after step of encapsulating and isotropically etching a portion of said material to provide a sidewall on said electrically conductive metal layer conformal to the sidewalls of said barrier layer and said anti-reflective layer.

**15.** A lead for use with a semiconductor device comprising:
a lead disposed on a surface of a substrate having an electrically conductive metal layer disposed over said surface;
an anti-reflective layer formed on said electrically conductive metal layer remote from said surface; and
a material to substantially prevent electromigration of said electrically conductive metal encapsulating said electrically conductive metal layer.

**16.** The lead of Claim 15, wherein said surface is further provided with a barrier layer disposed between said surface and said electrically conductive layer.

**17.** The lead of Claim 16, wherein said material encapsulates said electrically conductive metal layer between said barrier layer and said anti-reflective layer.

**18.** The lead of any of Claims 15 to 17, wherein said material is selected from a group of materials comprising TiN, W, Ti and Si₃N.

**19.** The lead of any of Claims 16 to 18, wherein said electrically conductive metal layer is indented relative to said barrier layer and said anti-reflective layer to form a substantially I-shape with said barrier layer and said anti-reflective layer.

**20.** The lead of Claim 19, wherein said material provides substantially vertical sidewalls on said lead from said barrier layer to said anti-reflective layer.

**21.** The lead of any of Claims 16 to 20, wherein said surface of said substrate comprises an oxide layer.

**22.** The lead of Claim 21, wherein said oxide layer further comprises a via with electrically conductive material therein extending from said barrier layer to said semiconductor material.

**22.** A lead for a semiconductor device comprising:
an electrically conductive metal region having a sidewall;
an anti-reflective coating disposed substantially at an end of said electrically conductive metal region said ends; and
a sidewall film disposed on said sidewall and encapsulating said electrically conductive region, said layer of barrier metal, and said anti-reflective coating.

**23.** The lead of Claim 22, wherein said anti-reflective coating and said sidewall film are formed from the same material.

**24.** The lead of Claim 22 or Claim 23, wherein said sidewall film formed from a material selected from a group of materials comprising: TiN, W, Ti, and Si₃N₄.
